Europäisches Patentamt

**European Patent Office**

**Office européen des brevets**

(11) Publication number: **0 387 438**
**A1**

# EUROPEAN PATENT APPLICATION

(21) Application number: **89302630.2**

(22) Date of filing: **17.03.89**

(51) Int. Cl.⁵: **F41G 7/00, G09B 9/00, G06F 15/60, F41G 3/26**

(43) Date of publication of application:
**19.09.90 Bulletin 90/38**

(84) Designated Contracting States:
**BE DE ES FR IT SE**

(71) Applicant: **BRITISH AEROSPACE PUBLIC LIMITED COMPANY**
**11 Strand**
**London WC2N 5JT(GB)**

(72) Inventor: **King, Anthony Stephen**
**British Aerospace Dynamics Ltd.**
**Manor Road Hatfield Herts AL10 9LL(GB)**
Inventor: **Waters, Toby Bryant**
**British Aerospace Dynamics Ltd.**
**Manor Road Hatfield Herts AL10 9LL(GB)**

(74) Representative: **Dowler, Edward Charles et al**
**British Aerospace plc Corporate IPR**
**Department, Headquarters P.O.Box 87**
**Building Q191 Royal Aerospace**
**Establishment**
**Farnborough Hants GU14 6YUJ(GB)**

(54) **Digital weapon simulator.**

(57) For testing air weapon systems which may be still at the design stage and the interaction of such systems with the launch aircraft, there is proposed a digital computer system in which there is implemented a missile to aircraft pylon interface, i.e. the drivers and such for say the MID-STE-1760 or 'Stanag' interface and a weapon simulator coupled to the interface. The weapon simulator is preferably modular so that parts of it may be inhibited and replaced by the appropriate real hardware items making up the eventual weapon as and when these items are prototyped. The aircraft itself would be real or it could be simulated by an aircraft avionics systems rig.

EP 0 387 438 A1

Some advanced air launched weapons, especially contemplated future weapons, require a capability for quite extensive digital data exchange with the launched aircraft. As a result, a major element in the design of such weapons is directed towards their integration with the data transmission system of the aircraft. A standard interface, called the MID-STD-1760 interface, has been introduced but this is not able, at least at present, to provide a fixed solution to the integration problem, i.e. practical differences say in data exchange protocols, polling strategies, information rates, data accuracies and cycling requirements between the various aircraft and weapon systems will inevitably arise. As will be appreciated, it would be of great advantage to resolve these integration problems before any equipment design is committed to hardware and the object of this invention is to provide a means for enabling this to be accomplished.

According to the invention there is provided a computer system in which there has been implemented a pylon interface for connection to a real or simulated aircraft data transmission system, and a weapon simulator coupled to said interface for onward transmission with said aircraft data communication system and operable to actively reproduce the characteristics of a weapon as seen from the aircraft.

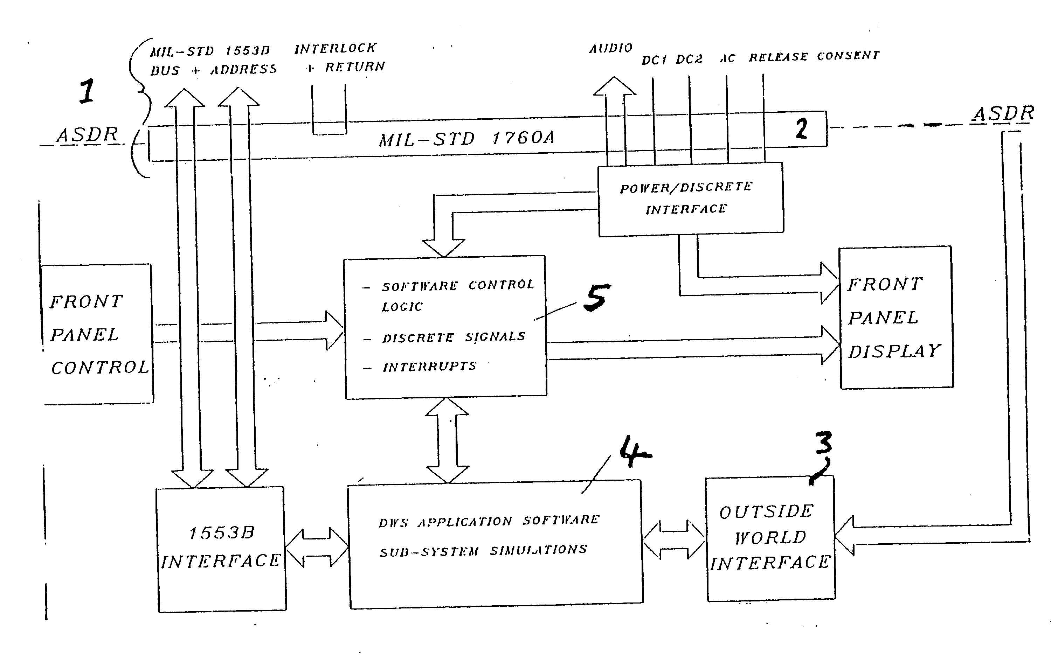

For a better understanding of the invention reference will now be made, by way of example, to the accompanying drawing, the single figure of which is a functional diagram of a weapon simulator coupled to a simulated aircraft data transmission system.

In the drawing, an aircraft data transmission system with a target simulator 1 are connected via respective interfaces 2 and 3 to the simulator which has software defining weapon simulations 4 and a control monitor module 5. The interface 2 comprises a hardware pylon interface, for example a mechanical arrangement in which all the connections specified by the MID-STD-1760A are implemented, and the necessary software portion of the interface, i.e. the interface driver and so on.

Particularly in relation to the development of aircraft data systems, it is known to 'simulate' parts of weapons by the simple connection to a weapon interface of passive components, for example resistors may be connected to the interface to act as loads for signals supplied by the aircraft system. The present simulator does much more than this however, namely it actually acts very substantially like a proposed real weapon in an active manner, e.g. by receiving and processing data from the aircraft system and passing back to the aircraft system. As a result the correct integration of the proposed weapon with the aircraft can be checked. A real weapon would of course receive some information other than from the launch aircraft - for example it may comprise a homing head which is required to lock onto a target in the 'real world'. The interface 3 and target simulation system acts to provide this 'outside world' information to the weapon simulator.

Advantageously the simulator is made so as to be readily adaptable and adjustable as regards information rates and so on and also in modular form so that various simulated items making up the weapon can be 'switched off' and replaced by an example, when made, of the real item so as then to check the operation of that real item in the context of the overall weapon.

## Claims

1. A computer system in which there has been implemented a pylon interface for connection to a real or simulated aircraft data transmission system, and a weapon simulator coupled to said interface for onward transmission with said aircraft data communication system and operable to actively reproduce the characteristics of a weapon as seen from the aircraft.

MIL-STD 1553B  INTERLOCK    AUDIO  DC1 DC2  AC  RELEASE CONSENT
BUS + ADDRESS   + RETURN

1

ASDR

MIL-STD 1760A    2    ASDR

POWER/DISCRETE
INTERFACE

FRONT
PANEL
CONTROL

- SOFTWARE CONTROL
  LOGIC
- DISCRETE SIGNALS
- INTERRUPTS

5

FRONT
PANEL
DISPLAY

1553B
INTERFACE

DWS APPLICATION SOFTWARE
SUB-SYSTEM SIMULATIONS

4

OUTSIDE
WORLD
INTERFACE

3

EP 0 387 438 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| E | EP-A-0 309 133 (BRITISH AEROSPACE PUBLIC CO. LTD)<br>* Whole document * | 1 | F 41 G 7/00<br>G 09 B 9/00<br>G 06 F 15/60<br>F 41 G 3/26 |
| Y | US-A-3 343 486 (M.W. PATRICK)<br>* Abstract; figure 5 * | 1 | |
| Y | US-A-3 932 843 (TRELUT et al.)<br>* Abstract; figures 1A,1B * | 1 | |
| A | GB-A-2 003 301 (BRITISH AIRCRAFT CORP. LTD)<br>* Whole document * | 1 | |
| A | US-A-4 555 756 (YAMANAKA K.K.)<br>* Whole document * | 1 | |
| A | GB-A-2 202 061 (THE BOEING CO.)<br>* Abstract; figures 1-4 * | 1 | |

| TECHNICAL FIELDS SEARCHED (Int. Cl.5) |
|---|
| F 41 G<br>G 09 B<br>G 06 F |

The present search report has been drawn up for all claims

| Place of search | Date of completion of the search | Examiner |
|---|---|---|
| THE HAGUE | 20-11-1989 | BLONDEL F.J.M.L.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)